Europäisches Patentamt

European Patent Office

Office européen des brevets

(11) Veröffentlichungsnummer: **0 022 486**
**A1**

(12) **EUROPÄISCHE PATENTANMELDUNG**

(21) Anmeldenummer: **80103488.5**

(22) Anmeldetag: **21.06.80**

(51) Int. Cl.³: **H 01 L 33/00**, H 05 B 33/02, H 01 L 29/06

(30) Priorität: **03.07.79 DE 2926803**

(43) Veröffentlichungstag der Anmeldung: **21.01.81 Patentblatt 81/3**

(84) Benannte Vertragsstaaten: **FR GB IT NL**

(71) Anmelder: **Licentia Patent-Verwaltungs-GmbH, Theodor-Stern-Kai 1, D-6000 Frankfurt/Main 70 (DE)**

(72) Erfinder: **Dahlberg, Reinhard, Dr., Innere Bergstrasse, D-7101 Flein (DE)**

(74) Vertreter: **Maute, Hans-Jürgen, Dipl.-Ing., Licentia Patentverwaltungs-GmbH Theodor-Stern-Kai 1, D-6000 Frankfurt/Main 70 (DE)**

(54) **Elektrolumineszierendes Halbleiter-Bauelement und Verfahren zu seiner Herstellung.**

(57) Es wird eine Elektrolumineszenz-Anordnung beschrieben, bei welcher mehrere sehr kleinflächige Elektrolumineszenz-Kontakte elektrisch parallel betrieben werden. Als Folge der extrem guten Wärmeableitung in sehr kleinen Kontakten können die Anordnungen ohne thermische Effekte mit höheren Leistungsdichten betrieben werden.

0022486

Licentia Patent-Verwaltungs-G.m.b.H
Theodor-Stern-Kai 1, 6000 Frankfurt 70

Heilbronn, den 16.10.79
SE2-HN-Ma/pf - HN 79/24

BEZEICHNUNG GEÄNDERT
siehe Titelseite

## Elektrolumineszenz-Anordnung

Die Erfindung beschreibt eine Elektrolumineszenz-Anordnung, bei der mehrere kleinflächige Elektrolumineszenz-Dioden in einer Anordnung elektrisch parallel geschaltet betrieben werden.

Festkörper-Elektrolumineszenz-Bauelemente, wie Leuchtdioden, Ziffern und Displays, finden heute vielfache Anwendung. Zum überwiegenden Teil werden heute p/n-Dioden aus sogenannten "Direkten Halbleitern", wie z. B. GaAs, GaAsP, GaP u. a. verwendet, die elektrisch in Flußrichtung betrieben werden.

Es gibt jedoch auch die Möglichkeit, Elektrolumineszenz-Dioden als Schottky-Dioden oder MOS-Dioden auszugestalten. Diese Bauelemente sind technologisch einfacher zu realisieren als p/n-Dioden, aber ihre Quantenausbeuten sind heute noch kleiner als bei p/n-Dioden. Elektrolumineszenz-Schottky-Dioden und MOS-Dioden bieten aber eine Reihe von Möglichkeiten, die noch nicht großtechnisch genutzt werden. So kann man z. B. mit einer GaAs-MOS-Dioden-Struktur eine weiße Lichtemission erzeugen (1).

Auch von Metall-Isolator-Metall (MIM)-Strukturen ist Lichtemission seit langem bekannt. So ist z. B. in Ta-Ta$_2$O$_5$-Au-oder Ti-TiO$_2$-Cu-Sandwich-Strukturen bei Anlegen einer Gleichspannung von 2 - 3 Volt, wobei der positive Pol an der Gold- bzw. Kupferschicht anliegt, die Emission von Licht mit Photon-Energien bis 1,8 eV zu beobachten. Die Intensität der Lichtemission und der Quantenwirkungsgrad hängen stark von der angelegten Spannung und der Stromdichte in den Sandwich-Strukturen ab, die oberhalb 1 Ampere/cm$^2$ und etwa 4 Volt im allgemeinen thermisch zerstört werden. Die Dicke der Ta$_2$O$_5$- und TiO$_2$-Schichten liegt zwischen 1 - 1,5.10$^{-6}$cm.

In neuerer Zeit ist eine Elektrolumineszenz-MIM-Struktur beschrieben worden, bei welcher durch Tunnelelektronen Oberflächen-Plasma-Zustände angeregt werden (2). Bei diesen Strukturen sind die Metall-Bereiche durch eine extrem dünne Isolator-Schicht, z. B. aus MgO, voneinander getrennt. Die Schichtdicken der Isolatorschichten liegen je nach der Höhe der Tunnel-Barriere zwischen 2 - 8.10$^{-7}$ cm. Das emittierte Licht zeigt eine cutoff-Frequenz $\gamma_{co} = \dfrac{eU}{h}$, die bei tiefen Temperaturen sehr ausgeprägt ist. Ein Ansteigen der angelegten Spannung erhöht die Lichtintensität und den Quantenwirkungsgrad der Emission, welche sich gleichzeitig nach kürzeren Wellenlängen verschiebt. Bei U $\approx$ 2,7 V und einer Stromdichte von ca. 1 Ampere/cm$^2$ liegen die Quantenwirkungsgrade bei etwa 1.10$^{-5}$. Bei höheren Spannungen neigen die Strukturen, vermutlich wegen der erfolgenden Erwärmung, zum Durchbruch.

Eine besondere Rolle spielt bei diesen Strukturen die Rauhigkeit der Unterlage, durch welche die Strahlungsemission induziert wird.

0022486

Alle Schottky-, MOS- und MIM-Tunnelstrukturen, aber auch einige p/n-Strukturen sind heute noch bezüglich der Helligkeit, dem Quantenwirkungsgrad der Lebensdauer verbesserungsfähig.

Die vorliegende Erfindung geht von der Erkenntnis aus, daß ein Teil dieser wünschenswerten Verbesserungen mit höheren Stromdichten erzielt werden könnten, wenn man die thermische Belastung bei höheren Stromstärken ausschalten könnte. Wenn es gelänge, die thermische Belastung z. B. durch eine wesentlich bessere Wärmeableitung vernachlässigbar klein zu halten, dann wären höhere Spannungen und Stromdichten applizierbar. Dies würde bei einigen Elektrolumineszenz-Bauelementen höhere Quantenwirkungsgrade und größere Helligkeit zur Folge haben. Die Erfindung hat sich die Lösung dieser Probleme zur Aufgabe gestellt. Diese Aufgabe wird erfindungsgemäß dadurch gelöst, daß zwei getrennte Körper vorgesehen sind, daß ein Körper aus lichtdurchlässigem Material besteht, daß der zweite Körper aus metallisch leitendem oder aus Halbleitermaterial besteht, daß ein Teil der Oberfläche mindestens eines Körpers eine Struktur mit mindestens drei Erhebungen aufweist, daß der lichtdurchlässige Körper mindestens teilweise mit einer lichtdurchlässigen elektrisch leitenden Schicht überzogen ist, und daß die beiden Körper so zusammengesetzt sind, daß sie an den die Berührungsstellen bildenden Erhebungen elektrische Kontakte bilden, die so ausgebildet sind, daß sie bei geeignetem Stromfluß zwischen dem Körper aus Halbleiter- oder elektrisch leitendem Material und der elektrisch leitenden Schicht auf dem lichtdurchlässigen Körper Licht in den lichtdurchlässigen Körper hinein emittieren.
Die Erfindung löst dabei das Problem der notwendigen wesentlich verbesserten Wärmeableitung nach dem Prinzip des Engewiderstandes in Kontakten.

Die beiden Körper aus lichtdurchlässigem Material und aus Halbleitermaterial oder elektrisch leitendem Material haben vorzugsweise die Form von Platten oder Scheiben. Die Platte oder Scheibe aus lichtdurchlässigem Material kann mit einer lichtdurchlässigen Metallschicht überzogen sein. Die zweite Platte oder Scheibe kann aus einkristallinem oder polykristallinem Halbleitermaterial bestehen. Ihre im zusammengesetzten Zustand der lichtdurchlässigen Platte oder Scheibe zugewandte Oberflächenseite kann einen p/n-Übergang und ihre andere Seite einen sperrfreien Kontakt haben. Die der lichtdurchlässigen Platte oder Scheibe zugewandte Oberflächenseite kann aber auch eine dünne Isolatorschicht tragen und die andere Seite kann einen sperrfreien Kontakt aufweisen.

Die zweite Platte oder Scheibe kann ferner aus Metall oder metallisch leitendem Material wie z. B. WC, $ZrB_2$, Graphit u. a. bestehen und auf einer ihrer Seiten mit der Schichtenfolge Halbleiter-Isolator oder Metall-dünne Isolatorschicht oder nur mit einer dünnen Isolatorschicht überzogen sein.

Die lichtdurchlässige Platte oder Scheibe kann auf einer ihrer Seiten auch mit der mindestens teilweise lichtdurchlässigen Schichtenfolge Metall-Isolator oder Metall-hochohmiger Halbleiter überzogen sein. Nach einem bevorzugten Ausführungsbeispiel der Erfindung haben die beiden Platten oder Scheiben auf einer ihrer beiden Seiten eine Struktur aus parallel zueinander verlaufenden Wällen, wobei beide Platten oder Scheiben so mit ihren strukturierten Seiten unter Druck zusammengesetzt sind, daß die Wälle beider Platten oder Scheiben sich kreuzen.

Das Prinzip der gekreuzten parallelen Wälle wird bereits in der Offenlegungsschrift P 25 47 262 beschrieben. Eine Herstellung von Elektrolumineszenz-Anordnungen nach diesem Prinzip wird dort jedoch nicht erwähnt.

Damit die dünnen Schichten beim Zusammensetzen der beiden Platten oder Scheiben unter Druck durch die stets vorhandenen Unebenheiten nicht verletzt werden, können die beiden Platten oder Scheiben mit ihren strukturierten Seiten vor dem Aufbringen der Metall-, Halbleiter- und Isolatorschichten erst einmal unter erhöhtem Druck zusammengesetzt werden. Durch plastische Deformation werden dabei die Unebenheiten ausgeglichen. Anschließend werden beide Platten oder Scheiben wieder getrennt, und nach dem Aufbringen der Metall-, Halbleiter- und Isolatorschichten werden die beiden Platten oder Scheiben mit ihren strukturierten Oberflächenseiten unter geringem Druck oder unter Verwendung einer dünnen Folie oder Schicht am Rand der beiden Platten oder Scheiben, die für einen definierten Abstand sorgt, in genau der gleichen Position wie beim ersten Zusammensetzen wieder zusammengefügt. Hierbei entstehen bei N parallel zueinander verlaufenden Wällen in den Strukturen beider Platten oder Scheiben insgesamt $N^2$ elektrisch parallel geschaltete Elektrolumineszenz-Kontakte. Da sich die Wälle stirnseitig auf sehr schmale Grate mit Durchmessern bis $< 1.10^{-4}$cm verjüngen können, lassen sich Kontakte mit Flächen $< 10^{-8}$cm$^2$ stabil herstellen.

Zum besseren Verständnis der Erfindung ist darauf hinzuweisen, daß die Temperaturerhöhung $\Delta T$ in einem stromdurchflossenen Engewiderstand $R_K$ (ohne "Fremdschicht") zwischen zwei Körpern mit dem elektrischen spezifischen Widerstand und der spez. Wärmeleitfähigkeit $\lambda$ in erster Näherung $\Delta T = \frac{U^2}{8 \varrho \lambda}$ ist. Dabei ist U die am Kontakt liegende Spannung. Da der elektrische Engewiderstand $R_K = \frac{\varrho}{2D}$ (mit 2D = Durchmesser des Kontaktes) ist, kann man mit dem Ausdruck für die elektrische Leistungsdichte

$$P = \frac{U^2}{R_K \cdot 4D^2} = \frac{U^2}{\varrho \cdot 2D} \left[ \frac{Watt}{cm^2} \right]$$

im Engewiderstand schreiben:

0022486

$$\Delta T = \frac{P \cdot \varsigma \cdot 2D}{8 \varrho \lambda} = \frac{P \cdot D}{4\lambda}$$

Dies bedeutet, daß bei gegebener Wärmeleitfähigkeit $\lambda$ die Temperaturerhöhung $\Delta T$ (die "Übertemperatur") als Folge einer bestimmten Leistungsdichte P umso kleiner ist, je kleiner der Durchmesser des Engewiderstandes ist. Wenn bei einem Elektrolumineszenz-Kontakt mit 1 mm$^2$ Fläche bei einer Leistungsdichte von 1 Watt/cm$^2$ die Erwärmung noch vernachlässigbar ist, dann ist für den gleichen Elektrolumineszenz-Kontakt mit einem Durchmesser von $1 \cdot 10^{-4}$ cm ($1 \cdot 10^{-8}$ cm$^2$ Fläche) die Erwärmung noch bei einer Leistungsdichte von 1 Kilowatt/cm$^2$ vernachlässigbar.

Als Materialien für die lichtdurchlässige Platte oder Scheibe können Quarz, Glas, anorganische Kristalle wie z. B. Saphir, Spinell oder auch organische Substanzen wie Polykarbonat, Polyacrylnitrit, Epoxyd u. a. verwendet werden.

Die strukturierte Oberflächenseite der lichtdurchlässigen Platte oder Scheibe kann bei den MIM-Tunnel-Anordnungen mit einer besonders großen Mikrorauhigkeit der Oberfläche hergestellt werden.

Als Halbleiter oder Halbleiterschichten können Elementhalbleiter, III/V-Verbindungshalbleiter, II/VI-Verbindungen u. a. in einkristalliner, polykristalliner oder amorpher Form verwendet werden.

Als Isolatorschichten können chemisch oder elektrochemisch erzeugte Oxyde, thermische Oxyde, pyrolythische Oxyde oder im Vakuum aufgedampfte reaktiv oder mit Hochfrequenz aufgestäubte Oxyde, Nitride, Boride, Karbide, Chalkogenide u. a. oder organische Isolatoren verwendet werden.

Die Elektrolumineszenz-Anordnung der Erfindung kann vorteilhafterweise als Leucht-Dioden, Leucht-Ziffern, Leucht-Displays und Bildschirmen ausgebildet werden. Da die Anordnung einen Betrieb mit extrem hohen Stromdichten ohne thermische Effekte erlaubt, ist auch ihre Ausbildung als LASER mit Vorteil möglich. Sie kann sogar als longitudinaler LASER ausgebildet werden. Wegen der hohen zulässigen Stromdichten ist dann nicht nur ein Impuls-Betrieb, sondern auch ein Dauerstrich-Betrieb bei Raumtemperatur möglich. Ferner lassen sich nach der Erfindung auch Injektions-LASER unter Verwendung von Halbleitermaterialien mit kleinerem oder größerem Bandabstand als GaAs, z. B. InSb, InAs, $InP_xAs_{1-x}$, $In_xGa_{1-x}As$, InP, PbS, PbTe, PbSe, $Pb_xSn_{1-x}Te$, $Cd_xHg_{1-x}Te$ oder $GaAs_xP_{1-x}$, CdS, CdTe, ZnTe, $Zn_xCd_{1-x}Te$, $ZnSe_xTe_{1-x}$, herstellen.

Im folgenden wird die Erfindung anhand von 8 Ausführungsbeispielen näher beschrieben.

Ausführungsbeispiel 1 beschreibt eine GaP-Leuchtdiode mit $p^+$/n-Struktur.

Ausführungsbeispiel 2 beschreibt eine blau-leuchtende ZnSe-Dioden-Anordnung.

Ausführungsbeispiel 3 beschreibt eine grün-leuchtende GaN-Elektrolumineszenz-Anordnung.

Ausführungsbeispiel 4 beschreibt eine GaAs-MOS-Anordnung für die Emission von weißem Licht.

Ausführungsbeispiel 5 beschreibt eine MIM-Anordnung.

Ausführungsbeispiel 6 beschreibt ein GaAs-MOS-Display.

Ausführungsbeispiel 7 beschreibt eine Elektrolumineszenz-Anordnung mit MIM-Tunnel-Kontakten als Bildschirm.

Ausführungsbeispiel 8 beschreibt einen longitudinalen GaAs-MOS-Injektions-LASER mit einer Einfach-Hetero-Struktur.


Ausführungsbeispiel 1

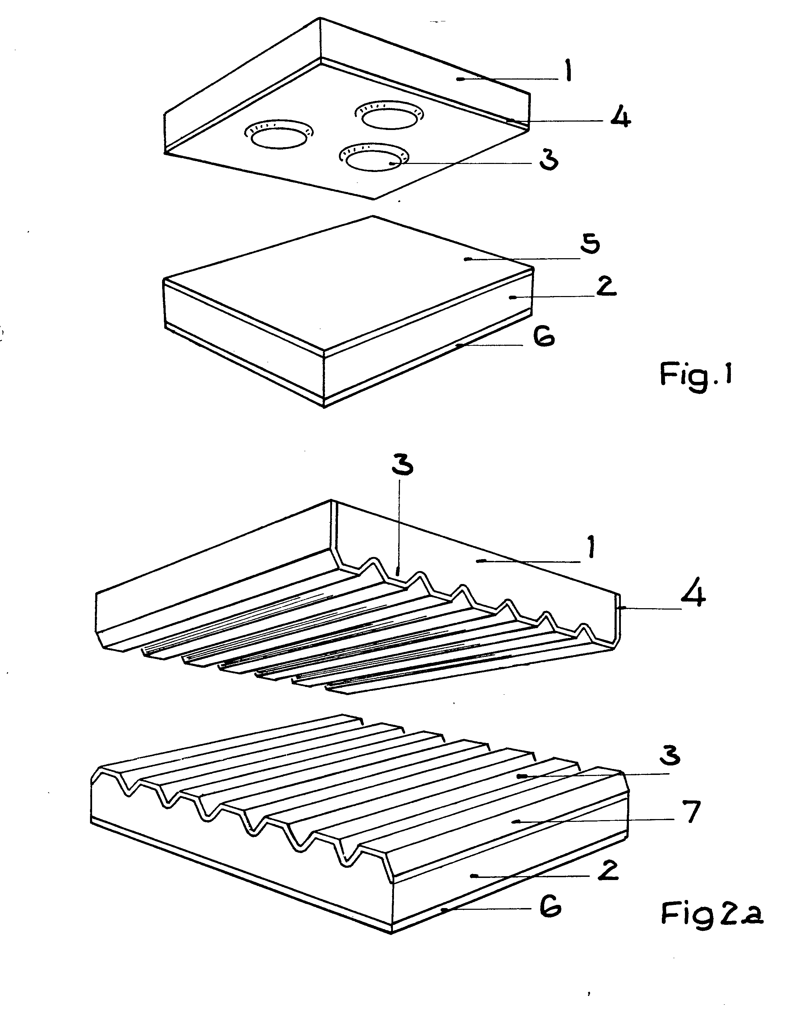

In Fig. 1 ist 1 eine Glasscheibe, die auf einer Oberflächenseite drei mesaförmige oder kegelstumpfförmige Erhebungen 3 aufweist. Zumindest die Erhebungen 3 sind mit einer ca. $2.10^{-6}$cm dicken Gold-Schicht 4 überzogen. 2 ist eine n-GaP-Scheibe mit einer Donatoren-Konzentration von ca. $1.10^{17}/cm^3$. Sie ist außerdem mit Stickstoff in einer Konzentration von $1.10^{18}/cm^3$ dotiert. Sie trägt auf der der Scheibe 1 zugewandten Oberflächenseite eine dünne $p^+$-GaP-Schicht 5, die mit der n-GaP-Scheibe 2 einen p/n-Übergang bildet. 6 ist ein sperrfreier Kontakt auf der der Schicht 5 gegenüberliegenden Oberflächenseite an der GaP-Scheibe 2. Die beiden Scheiben 1 und 2 werden unter mechanischem Druck so aufeinandergelegt, daß die mit der lichtdurchlässigen Goldschicht 4 überzogenen Erhebungen 3 an den Berührungsstellen mit der Scheibe 2 drei elektrische Druck-Kontakte bilden. Da mindestens 3 Erhebungen auf der Scheibe 1 angeordnet sind, ist die mechanische Stabilität der Gesamtanordnung gewährleistet.


Ausführungsbeispiel 2

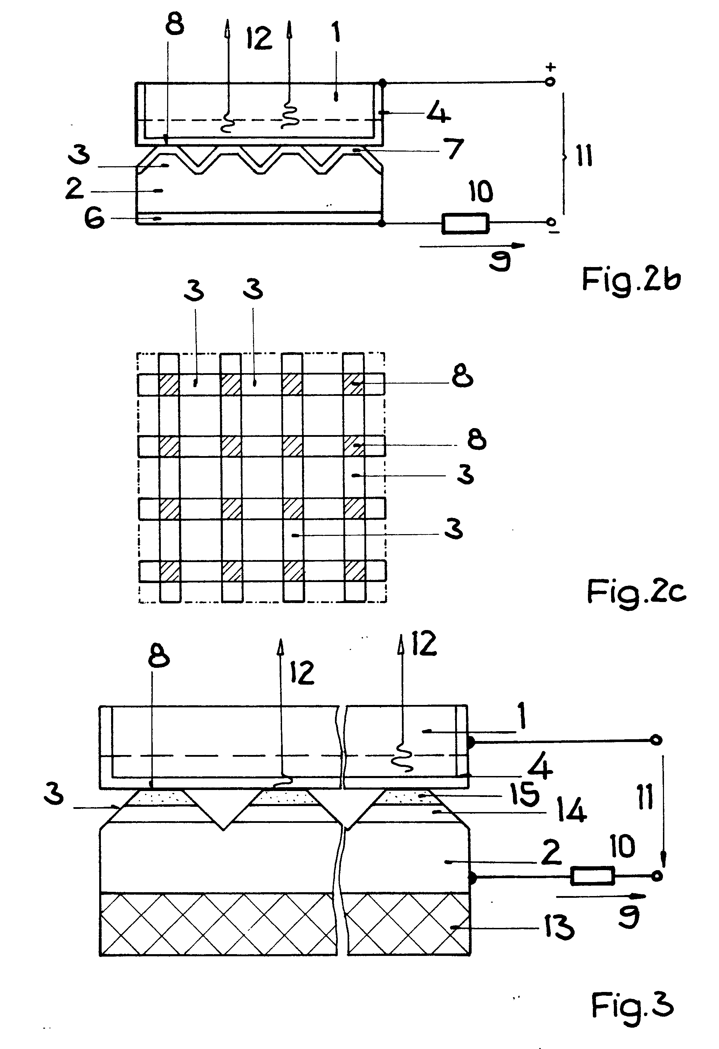

In Fig. 2 ist 1 wiederum eine Glasplatte, in welche beispielsweise über einen Sägeprozess eine Struktur aus parallel zueinander verlaufenden, sich zur Stirnseite hin verjüngenden Wällen 3, die durch entsprechende Gräben voneinander getrennt sind, eingebracht wurde. Die Wälle 3 haben an ihrer Stirnseite eine Breite von ca. $1.10^{-2}$cm. Diese strukturierte Oberflächenseite mit den Wällen 3 ist mit einer Goldschicht 4 von ca. $2.10^{-6}$cm Dicke überzogen. 2 ist eine n-GaAs-Platte, welche mit $5.10^{17}$ Te-Atomen/cm$^3$ dotiert ist. 6 ist ein legierter Sn-Kontakt an der unstrukturierten Oberflächenseite dieser Scheibe. In die GaAs-Scheiben 2 wurde auf der dem Kontakt 6 gegenüberliegenden Oberflächenseite eine ähnliche Struktur paralleler Wälle und Gräben eingebracht wie in die Glasscheibe 1. Auf diese Struktur der GaAs-Scheibe 2 wurde eine ZnSe-Schicht 7, die beispielsweise mit 0,27 Gewichtsprozenten $MnF_2$ dotiert ist, durch Aufdampfen im Hochvakuum mit einer Dicke von $4.10^{-5}$cm aufgebracht. Die beiden Scheiben 1 und 2 werden mit ihren strukturierten Oberflächenseiten, wobei die Scheiben bezüglich ihrer Strukturen um ca. 90° gegeneinander verdreht sind, zusammengesetzt, so daß sich die Wälle der Strukturen kreuzen und berühren, wie dies aus der Fig. 2 a deutlich wird. Eine zusammengesetzte Elektrolumineszenz-Anordnung mit sechzehn elektrisch parallel geschalteten Kontakten 8 ist im Schnitt in Fig. 2 b und mit einem Schnitt durch die Berührungsebene beider Scheiben in Fig. 2 c dargestellt. Über den Widerstand 10 wird die Gleichspannung 11 von 25 Volt zwischen die Goldschicht 4 (positiver Pol) und den sperrfreien Kontakt 6 an der GaAs-Scheibe 2 gelegt. Dadurch fließt der Strom 9 durch die Kontakte 8 und verursacht eine Lichtemission 12 mit einer Wellenlänge von etwa $5,8.10^{-5}$cm (5800 Å).

Ausführungsbeispiel 3

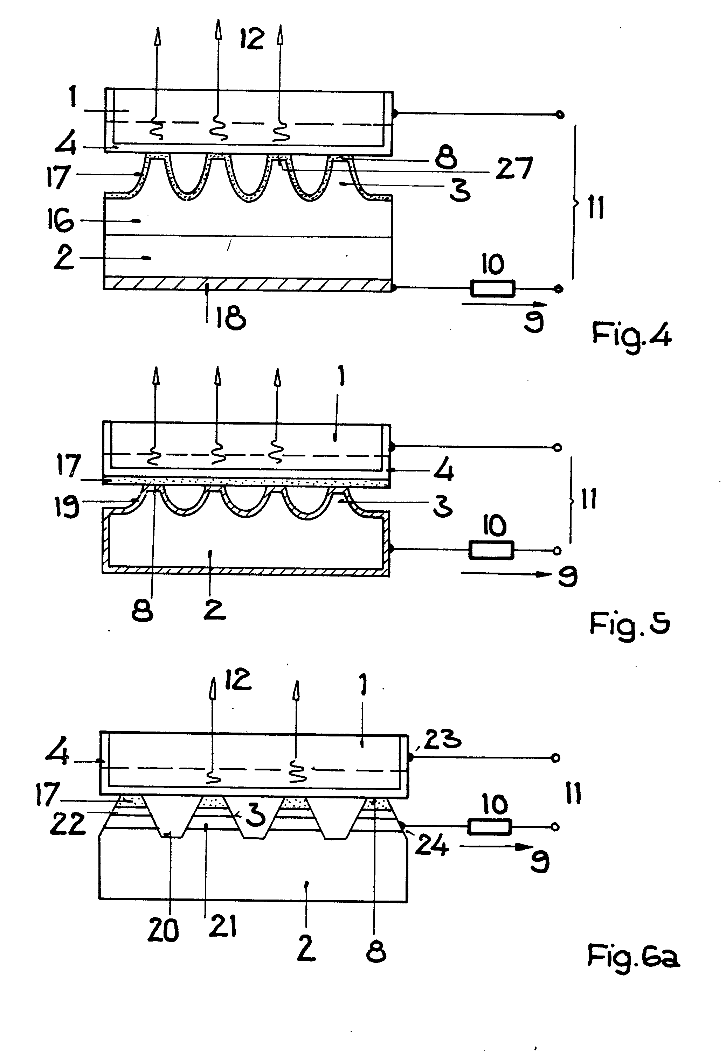

In der Schnittdarstellung der Fig. 3 ist 1 eine Glasscheibe mit einer Struktur aus parallel zueinander verlaufenden Wällen 3, die an der schmalsten Stelle - an ihrer abge-

flachten Stirnseite - $2.10^{-2}$ cm breit sind. Die Oberflächenseite mit der Struktur ist mit einer $1.10^{-4}$ cm dicken Goldschicht 4 überzogen, welche an der $2.10^{-2}$ cm breiten Stirnfläche der Wälle nur $1,5.10^{-6}$ cm dick ist. 2 ist eine $2.10^{-3}$ cm dicke $n^+$-GaN-Schicht, die beispielsweise in einer Stickstoff-Atmosphäre bei 950 °C auf eine (0001) Saphir-Platte 13 aufgewachsen wurde. Auf die Schicht 2 wurde ferner eine Zn-dotierte n-GaN-Schicht 14 von $1.10^{-3}$ cm Dicke aufgewachsen. Auf diese n-GaN-Schicht 14 wurde eine $1.10^{-5}$ cm dicke semi-isolierende GaN-Schicht 15 mit einer Zn-Konzentration von ca. $1.10^{20}/cm^3$ aufgewachsen. In die Oberfläche des so entstandenen Körpers wurden zur Herstellung der Wälle 3 Gräben eingebracht, die die Schichten 15 und 14 durchdringen und bis in die Schicht 2 reichen. Die Wälle sind an der Basis ca. $2.10^{-2}$ cm breit und verjüngen sich bis zu den Graten 27 auf eine Restbreite von $1,5.10^{-3}$ cm. Die Scheibe 1 und die Saphir-Platte 13 mit den Schichten 2, 14 und 15 werden mit ihren strukturierten Oberflächenseiten, die bezüglich der Wallstrukturen um 90° gegeneinander verdreht sind, unter Druck zusammengesetzt und fixiert. Dadurch sind an den Berührungsstellen der sich kreuzenden Wälle 3 die GaN-MIS-Kontakte 8 entstanden. Bei Anlegen der Spannung 11 von ca. 10 Volt über den Widerstand 10 an die Goldschicht 4 und die $n^+$-GaN-Schicht 2 fließt der Strom 9 durch die MIS-Kontakte 8 und verursacht die Emission von grünem Licht 12 mit einem externen Quantenwirkungsgrad von rund 1 %.

Ausführungsbeispiel 4

In Fig. 4 ist 1 eine Scheibe aus Polykarbonat, die auf der Unterseite eine Struktur aus parallel zueinander verlaufenden, sich bis auf eine Breite von $5.10^{-3}$ cm verjüngenden Wällen 3 hat. 4 ist eine lichtdurchlässige Goldschicht auf dieser Struktur. 2 ist eine $n^{+}$-GaAs-Substratscheibe, auf die eine n-GaAs-Schicht 16 mit einer Trägerkonzentration von $2.10^{16}/cm^3$ abgeschieden wurde. In diese n-GaAs-Schicht 16 wurde eine Struktur aus parallel zueinander verlaufenden, sich bis auf eine Breite an der Grat- oder Stirnfläche 27 von $2.10^{-3}$ cm verjüngenden Wällen 3 eingebracht. Durch eine chemische Behandlung wurde diese Struktur mit einer $5.10^{-7}$ cm dicken natürlichen Oxydschicht 17 überzogen. 18 ist ein legierter Indiumkontakt an der Substratscheibe 2. Die beiden Scheiben 1 und 2 wurden bezüglich der einander zugewandten Wallstrukturen in der Scheibenebene gegeneinander um 90° verdreht, unter Druck zusammengesetzt und mechanisch fixiert. Die sich dabei überkreuzenden und berührenden Wälle 3 bilden sechzehn Elektrolumineszenz-Kontakte 8 mit je einer Fläche von $5.10^{-3} \times 2.10^{-3} = 10^{-5}$ $cm^2$. Über den Widerstand 10 wird die Gleichspannung 11 an die Elektrolumineszenz-Anordnung zwischen die Au-Schicht 4 und den Indiumkontakt 18 gelegt. Der dann durch die Kontakte 8 fließende Strom 9 verursacht die Emission von weißem Licht 12.

Ausführungsbeispiel 5

In Fig. 5 ist 1 eine planpolierte Glasscheibe. Sie hat durch einen leichten Ätzangriff mit gasförmiger HF eine erhöhte Mikrorauhigkeit erhalten. Die Unterseite hat eine Struktur aus parallel zueinander verlaufenden, sich auf eine Breite von $1.10^{-3}$ cm verjüngenden Wällen 3, und ist mit einer Aluminiumschicht 4 mit einer Dicke von $2,5.10^{-6}$ cm überzogen. Ein Teil der Schichtdicke des Aluminiums 4 wurde durch anodische Oxidation im Plasma in eine etwa $5.10^{-7}$ cm dicke $Al_2O_3$-Schicht 17 umgewandelt. 2 ist eine planpolierte Kupferscheibe, die auf einer Seite ebenfalls eine Struktur paralleler Wälle 3 trägt, die sich an der Stirnseite auf eine Breite von $1.10^{-3}$ cm verjüngen. Die Kupferscheibe 2 ist mit einer Goldschicht 19 von $2.10^{-4}$ cm Dicke überzogen. Beide Scheiben 1 und 2 werden mit ihren strukturierten Oberflächenseiten unter Druck so zusammengehalten, daß die sich kreuzenden und berührenden Wälle 3 an den Berührungsstellen sechzehn MIM-Tunnelstrukturen 8 mit je einer Fläche von $1.10^{-6}$ cm$^2$ bilden. Die Gleichspannung 11 von ca. 3 Volt wird über den Widerstand 10 zwischen die Aluminiumschicht 4 und die Goldschicht 19 der Kupferscheibe 2 gelegt. Als Folge des die MIM-Strukturen 8 durchfließenden Stromes 10 wird die Strahlung 12 emittiert, deren cutoff-Frequenz $\gamma = \frac{eU}{h}$ von der angelegten Spannung abhängt.

## Ausführungsbeispiel 6

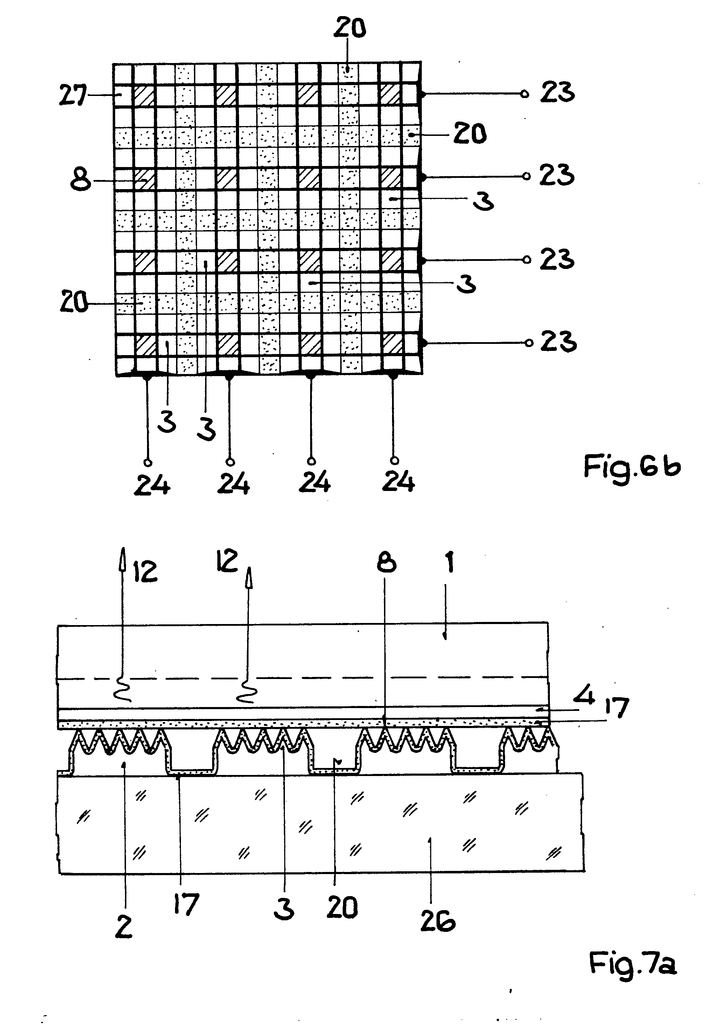

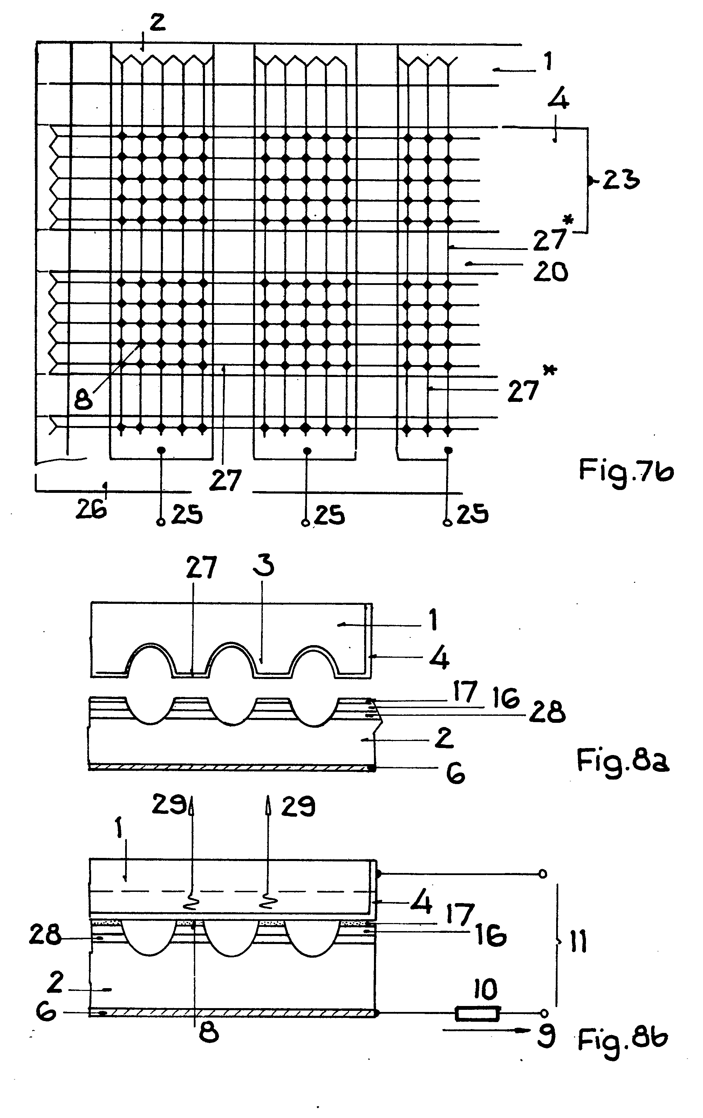

In Fig. 6a ist 2 eine einkristalline semi-isolierende GaAs-Scheibe. Sie trägt ausgehend vom GaAs-Körper auf einer Seite die epitaktische Schichtenfolge: p$^+$-GaAs 21, mit einer Dicke von ca. $3.10^{-3}$ cm, p-GaAs 22, mit einer Dicke von ca. $1.10^{-3}$ cm, Siliziumnitrid 17, mit einer Dicke von ca. $5.10^{-7}$ cm. In diese Schichtenfolge wurden zur Erzeugung von parallel zueinander verlaufenden Wällen 3 bis in die GaAs-Scheibe 2 reichende Gräben 20 eingebracht. Die parallel zueinander verlaufenden Wälle 3 verjüngen sich bis auf eine Breite der Grate 27 (Fig. 6b) von $1.10^{-2}$ cm.
Die Scheibe 1 ist eine planparallele Glasscheibe, die auf ihrer Unterseite ebenfalls eine Struktur aus parallel zueinander verlaufenden Wällen 3 hat, die sich bis auf eine Breite der Grate 27 von $1.10^{-2}$ cm verjüngen. Die Oberfläche der Wälle 3 ist mit einer Aluminiumschicht 4 von $2.10^{-6}$ cm Dicke überzogen, die sich nicht bis zur Talsohle der zwischen den Wällen liegenden Gräben erstreckt.

Die beiden Scheiben 1 und 2 werden mit ihren strukturierten Oberflächenseiten - in der Scheibenebene bezüglich der Strukturen gegeneinander um 90° verdreht - unter definiertem Druck zusammengesetzt und fixiert.

Dadurch sind sechzehn MOS-Kontakte 8 entstanden, die getrennt über die Kontakte 23 an der Aluminiumschicht 4 und 24 an der GaAs-Schicht 21 über den Widerstand 10 an die Spannung 11 geschaltet werden können.

Fig. 6b zeigt schematisch in einem Schnitt durch die Berührungsebene der beiden Scheiben 1 und 2 die sechzehn MOS-Kontakte 8. Da die Gräben 20 sowohl die Aluminiumbahnen $\underline{4}$ als auch die $n^+$-GaAs-Bahnen 21 elektrisch trennen, sind die MOS-Kontakte 8 über Kontaktpaare 23/24 getrennt an die Spannung 11 anschließbar. Der dann fließende Strom 9 verursacht die Emission von weißem Licht mit einem Wellenlängenbereich von $4 - 8.10^{-5}$ cm.

Ausführungsbeispiel 7

In Fig. 7a ist 1 eine Glasplatte von 15 x 15 cm, welche einseitig eine Struktur von parallel zueinander verlaufenden, sich auf einen Grat 27 (Fig. 7b) mit einer Breite von $1.10^{-3}$ cm verjüngenden Wällen 3 aufweist. Der Abstand der Grate 27 zweier benachbarter Wälle 3 beträgt $2.10^{-3}$ cm. Auf diese Struktur sind 625 Magnesiumstreifen 4 mit einer Breite von $1.10^{-2}$ und einer Dicke von $3,5.10^{-6}$ cm in einem Abstand von $5.10^{-3}$ cm und parallel zu den Wällen 3 verlaufend im Hochvakuum aufgedampft. Ein Teil dieser Schichtdicke ist im Plasma zu einer MgO-Schicht 17 von $3.10^{-7}$ cm Dicke oxydiert.

2 sind 640 Silber-Bahnen mit einer Dicke von $5.10^{-3}$ cm und einer Breite von $1.10^{-2}$ cm, die im Abstand 20 von $5.10^{-3}$ cm auf eine Aluminiumoxydplatte 26 von 15 x 15 cm parallel zueinander verlaufend aufgebracht wurden. Jede Silber-Bahn 2 trägt auf ihrer Oberfläche eine Struktur von 5 parallelen, sich auf einen Grat $27^x$ von $1.10^{-3}$ cm verjüngenden Wällen 3. Die gesamte Oberfläche der Aluminiumplatte 26 mit den Silberbahnen 2 wurde mit einer $3.10^{-7}$ cm dicken MgO-Schicht 17 im Hochvakuum bedampft. Die Scheibe 1 wird bezüglich der Strukturen um 90° in der Scheibenebene gegen die Platte 26 verdreht auf die Aluminiumoxydplatte 26 mit den Silber-Bahnen 2 so aufgesetzt, daß sich die Magnesiumstreifen 4 auf den Wallstrukturen der Scheibe 1 und die Silber-Bahnen 2 kreuzen, so daß die Grate 27 der Wälle 3 in der Struktur der Platte 1 und die Grate $27^x$ in der Struktur der Silber-Bahnen 2 MIM-Tunnel-Kontakte 8 bilden. Jede Kreuzung einer Silber-Bahn 2 mit einem Magnesium-Streifen 4 bildet fünfundzwanzig elektrisch parallel geschaltete MIM-Tunnel-Kontakte 8 von je $1.10^{-6}$ cm$^2$ Fläche, wie dies in Fig. 7b durch eine Darstellung der Berührungsebene beider Platten angedeutet ist. Über die Kontaktanschlüsse 23 an den Magnesiumstreifen 4 und die Kontaktanschlüsse 25 an den Silber-Bahnen 2 ist jeder Bildpunkt, der aus fünfundzwanzig elektrisch parallel geschalteten MIM-Tunnel-Kontakten 8 besteht, getrennt ansteuerbar. Durch Anlegen einer Spannung an ein Kontaktanschlußpaar 23/25 emittieren die fünfundzwanzig MIM-Tunnel-Kontakte 8 Licht 12 (Fig. 7a), dessen Frequenzgrenze von der Höhe der angelegten Spannung abhängt. Zur Bilderzeugung stehen 625 x 640 fünfundzwanzigfach Bildpunkte auf einer aktiven Fläche von ca. 12 x 12 cm zur Verfügung.

Ausführungsbeispiel 8

In Fig. 8a ist 1 eine Glasplatte, welche auf einer Seite eine Struktur parallel verlaufender Wälle 3 hat. Die Struk-

0022486

tur und die Seitenflächen der Glasplatte 1 sind mit einer Goldschicht 4 überzogen, welche auf den Graten 27 der Wälle 3 nur $1.10^{-6}$ cm dick ist. Die Grate 27 haben eine Breite von $5.10^{-4}$ cm. Die Wälle 3 haben einen Abstand von $5.10^{-3}$ cm voneinander.

2 in Fig. 8a ist eine einkristalline $n^+$-GaAs-Platte, welche auf einer Seite den sperrfreien Kontakt 6 hat. Auf der anderen Seite ist eine $1 - 2.10^{-4}$ cm dicke einkristalline Schicht 28 aus $n-Al_xGa_{1-x}As$ aufgebracht (mit $0,3 < x < 0,8$). Auf dieser Schicht 28 ist eine n-GaAs-Schicht 16 mit einer Trägerkonzentration von ca. $10^{15}/cm^3$ und einer Dicke von ca. $5.10^{-5}$ cm epitaktisch aufgebracht. Die n-GaAs-Schicht 16 trägt eine durch Oxydation erzeugte Isolatorschicht 17 mit einer Dicke von ca. $5.10^{-7}$ cm. Die Platte 2 hat ebenfalls eine Struktur aus parallel zueinander verlaufenden Wällen 3, wie in Fig. 8a im Querschnitt schematisch angedeutet. Die die Wälle 3 trennenden Gräben durchdringen die Schichten 17, 16 und 28 und reichen bis in den GaAs-Körper 2. An den Graten 27 ist die Breite der Wälle 3 $1.10^{-3}$ cm. Die parallelen Wälle 3 haben einen Abstand von $5.10^{-3}$ cm voneinander. Die beiden Platten 1 und 2 werden - wie in Fig. 8b angedeutet - in der Plattenebene um 90° gedreht aufeinandergelegt, so daß sich die Wälle beider Platten 1 und 2 kreuzen und berühren. Dadurch werden $5.10^{-4} \times 5.10^{-4}$ cm große Kontaktflächen 8 gebildet. Durch Anlegen der Flußspannung 11 über den Vorwiderstand 10 fließt ein elektrischer Strom 9 über die durch die Berührungsflächen beider Platten 1 und 2 gebildeten Kontakte 8 mit einer Stromdichte von ca. $2.10^7$ Ampere/$cm^2$. Als Folge der hohen Stromdichte tritt eine kohärente Strahlung 29 in longitudinaler Richtung aus der aktiven GaAs-Schicht 16 aus. Sie kann in an sich bekannter Weise über mechanischen Druck oder ein Magnetfeld variiert werden.

Literatur

(1)     B. Bayraktaroglu, H. L. Hartnagel
        "White-Light-Emission from GaAs M.O.S.Structures"
        Electronics Letters 14, 470-472 (1978)


(2)     S. L. Mc Carthy and John Lambe
        "Enhancement of light emission from metalinsulator-metal tunnel junctions"
        Appl. Physics Letters 30, 427 - 429 (1977)

Elektrolumineszenz-Anordnung

## Bezugsziffern

| | |
|---|---|
| 1 | Körper aus lichtdurchlässigem Material |
| 2 | Körper aus Halbleiter- oder metallisch leitendem Material |
| 3 | Erhebung oder Wall |
| 4 | elektrisch leitende Schicht |
| 5 | $p^+$-GaP-Schicht |
| 6 | sperrfreier Kontakt |
| 7 | ZnSe-Schicht |
| 8 | elektrischer Kontakt |
| 9 | elektrischer Strom |
| 10 | elektrischer Widerstand |
| 11 | elektrische Spannungsquelle |
| 12 | Lichtemission |
| 13 | Saphir-Platte |
| 14 | n-GaN-Schicht |
| 15 | semi-isolierende GaN-Schicht |
| 16 | n-GaAs-Schicht |
| 17 | dünne Isolatorschicht |
| 18 | legierter Indium-Kontakt |
| 19 | Goldschicht |
| 20 | Isolierender Graben |
| 21 | $p^+$-GaAs-Schicht |
| 22 | p-GaAs-Schicht |
| 23 | elektrischer Anschluß an eine einzelne Bahn von 4 |
| 24 | elektrischer Anschluß an eine einzelne Bahn von 21 |
| 25 | elektrischer Anschluß an eine einzelne Bahn von 2 |
| 26 | Aluminiumoxyd-Platte |
| 27 | Grat eines Walls 3 |
| 28 | n-Al$_x$Ga$_{1-x}$As-Schicht $(0,3 < x < 0,8)$ |
| 29 | kohärente Lichtemission |

Licentia Patent-Verwaltungs-G.m.b.H.
Theodor-Stern-Kai 1, 6000 Frankfurt 70


Heilbronn, den 16.10.79
SE2-HN-Ma/pf - HN 79/24


Patentansprüche


1) Elektrolumineszenz-Anordnung dadurch gekennzeichnet,
daß zwei getrennte Körper (1,2) vorgesehen sind, daß ein
Körper (1) aus lichtdurchlässigem Material besteht, daß
der zweite Körper (2) aus metallisch leitendem Material
oder aus Halbleitermaterial besteht, daß ein Teil der Oberfläche mindestens eines Körpers (1,2) eine Struktur mit
mindestens drei Erhebungen (3) aufweist, daß der lichtdurchlässige Körper (1) mindestens teilweise mit einer
lichtdurchlässigen elektrisch leitenden Schicht (4) überzogen ist, und daß die beiden Körper (1,2) so zusammengesetzt sind, daß sie an den die Berührungsstellen bildenden
Erhebungen (3) elektrische Kontakte bilden, die so ausgebildet sind, daß sie bei geeignetem elektrischem Stromfluß (9)
zwischen dem Körper aus Halbleiter- oder elektrisch leitendem Material (2) und der elektrisch leitenden Schicht (4)
auf dem lichtdurchlässigen Körper (1) Licht (12) in den
lichtdurchlässigen Körper (1) hinein emittieren.

2) Elektrolumineszenz-Anordnung nach Anspruch 1, dadurch gekennzeichnet, daß die beiden Körper (1,2) die Form von Platten oder Scheiben haben.

3) Elektrolumineszenz-Anordnung nach einem der vorhergehenden Ansprüche, dadurch gekennzeichnet, daß die Struktur der lichtdurchlässigen Platte oder Scheibe (1) mit einer Metallschicht (4) überzogen ist, und daß die zweite Platte oder Scheibe (2) aus einkristallinem oder polykristallinem Halbleitermaterial besteht, und auf einer ihrer Seiten einen sperrfreien Kontakt (6) und auf der anderen, der lichtdurchlässigen Platte oder Scheibe (1) zugewandten Oberflächenseite eine Halbleiterschicht (5) aufweist, die mit der Platte oder Scheibe (2) einen pn-Übergang bildet.

4) Elektrolumineszenz-Anordnung nach einem der vorhergehenden Ansprüche, dadurch gekennzeichnet, daß die zweite Platte oder Scheibe (2) aus einkristallinem oder polykristallinem Halbleitermaterial besteht und daß sie auf einer ihrer Oberflächenseiten einen sperrfreien Kontakt (6) und auf der anderen, der ersten Scheibe oder Platte zugewandten Oberflächenseite eine dünne Isolatorschicht (17) aufweist.

5) Elektrolumineszenz-Anordnung nach einem der vorhergehenden Ansprüche, dadurch gekennzeichnet, daß die zweite Platte oder Scheibe (2) aus metallisch leitendem Material besteht und auf der der ersten Platte oder Scheibe zugewandten Oberflächenseite mit der Schichtenfolge Halbleiter/Isolatorschicht oder mit einer dünnen Isolatorschicht überzogen ist.

6) Elektrolumineszenz-Anordnung nach einem der vorhergehenden Ansprüche, dadurch gekennzeichnet, daß die lichtdurchlässige Platte (1) auf der der zweiten Platte zugewandten Oberflächenseite mit einer Schichtenfolge Metall/Isolator oder Metall/hochohmiger Halbleiter überzogen ist.

- 3 -          0022486

7) Elektrolumineszenz-Anordnung nach einem der vorhergehenden Ansprüche, dadurch gekennzeichnet, daß die beiden Platten oder Scheiben (1,2) auf je einer ihrer beiden Oberflächenseiten eine Struktur aus parallel zueinander verlaufenden Wällen (3) haben, und daß die beiden Platten oder Scheiben (1,2) mit ihren strukturierten Oberflächen-Seiten, - die bezüglich der Strukturen in der Scheibenebene gegeneinander verdreht sind, - unter mechanischem Druck so zusammengesetzt sind, daß die Wälle beider Platten sich berühren und kreuzen.

8) Elektrolumineszenz-Anordnung nach einem der vorhergehenden Ansprüche, dadurch gekennzeichnet, daß als lichtdurchlässiges Material Quarz, Glas, anorganische Kristalle wie z. B. Saphir oder Spinell oder auch organische Substanzen wie z. B. Polyacrylnitril, Polycarbonat, Epoxyd u. a. vorgesehen ist.

9) Elektrolumineszenz-Anordnung nach einem der vorhergehenden Ansprüche, dadurch gekennzeichnet, daß die strukturierte Seite der lichtdurchlässigen Platte oder Scheibe (1) einen besonders hohen Grad an Mikrorauhigkeit aufweist.

10) Elektrolumineszenz-Anordnung nach einem der vorhergehenden Ansprüche, dadurch gekennzeichnet, daß als Halbleiter oder Halbleiterschichten Element-Halbleiter, III/V-Verbindungshalbleiter oder II/VI-Verbindungen vorgesehen sind.

11) Elektrolumineszenz-Anordnung nach einem der vorhergehenden Ansprüche, dadurch gekennzeichnet, daß als Isolator-Schichten anodische Oxyde, thermische Oxyde, Nitride, Boride, Carbide, Chalkogenide oder organische Isolatorschichten vorgesehen sind.

- 4 -    0022486

12) Elektrolumineszenz-Anordnung nach einem der vorhergehenden Ansprüche, gekennzeichnet durch ihre Verwendung als Leucht-Diode.

13) Elektrolumineszenz-Anordnung nach einem der vorhergehenden Ansprüche, gekennzeichnet durch ihre Verwendung als Festkörper-LASER.

14) Elektrolumineszenz-Anordnung nach einem der vorhergehenden Ansprüche, gekennzeichnet durch ihre Verwendung als Display oder Festkörper-Bildschirm.

15) Verfahren zur Herstellung einer Elektrolumineszenz-Anordnung nach einem der vorhergehenden Ansprüche, dadurch gekennzeichnet, daß die beiden Platten oder Scheiben (1,2) mit ihren strukturierten Oberflächenseiten vor Aufbringung der Metall-, Halbleiter- oder Isolator-Schichten unter Druck zusammengesetzt werden, daß sie anschließend wieder getrennt werden, und daß nach dem Aufbringen der Metall-, Halbleiter- oder Isolator-Schichten die beiden Platten oder Scheiben mit den strukturierten Oberflächenseiten unter geringem Druck oder unter Verwendung einer Abstands-Folie oder einer Abstands-Schicht in der genau gleichen Position wie bei dem ersten Zusammendrücken wieder zusammengesetzt werden.

0022486

Fig.1

Fig2a

0022486

Fig.2b

Fig.2c

Fig.3

Fig.4

Fig.5

Fig.6a

Fig.6b

Fig.7a

0022486

Fig.7b

Fig.8a

Fig.8b

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A1 - 2 716 205  (MATSUSHITA ELECTRIC INDUSTRIAL) <br> * Anspruch 1; Seite 9; Fig. 3 * | 1-3,6, 10,12, 14 |
| | -- | |
| | DE - A - 1 514 727 (SCHÄFER) <br> * Patentanspruch * | 7,10 |
| | -- | |
| | DE - B - 1 957 390 (MATSUSHITA ELECTRONICS) <br> * Fig. 1 bis 3 * | 1,2 |
| | -- | |
| | US - A - 3 309 553 (VARIAN ASSOCIATES) <br> * Ansprüche 2 bis 4; Spalte 5, Zeilen 31 bis 55; Fig. 6 * | 7,10, 14 |
| | -- | |
| | US - A - 4 039 890 (MONSANTO) <br> * Zusammenfassung; Fig. 4 * | 7,10, 14 |
| | -- | |
| | US - A - 3 930 912 (MARCONI CO.LTD.) <br> * Anspruch 1; Fig. 5 * | 7 |
| | -- | |
| | GB - A - 1 350 803 (GENERAL ELECTRIC) <br> * Anspruch 6; Seite 4, Zeilen 36 bis 53; Fig. 10 * | 7,10, 14 |
| | -- | |
| | ./.. | |

**KLASSIFIKATION DER ANMELDUNG (Int.Cl.3)**

H 01 L 33/00
H 05 B 33/02
H 01 L 29/06

**RECHERCHIERTE SACHGEBIETE (Int. Cl.3)**

H 01 L 21/18
H 01 L 29/06
H 01 L 33/00
H 05 B 33/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 15-10-1980 | ROTHER |

EPA form 1503.1  06.78

**Europäisches Patentamt**

**EUROPÄISCHER RECHERCHENBERICHT**

0022486
Nummer der Anmeldung

EP 80 10 3488.5
- Seite 2 -

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| P | Patents Abstracts of Japan Band 3, Nr. 115(E-140), 22. September 1979, Seite 129 E 140 | |
| P | & JP - A - 54 - 93388 | |
| P | DE - A1 - 2 837 394 (SEMIKRON GESELLSCHAFT FÜR GLEICHRICHTERBAU UND ELEKTRONIK MBH) * Fig. * | 7 |

**KLASSIFIKATION DER ANMELDUNG (Int.Cl.3)**

**RECHERCHIERTE SACHGEBIETE (Int. Cl.3)**

EPA Form 1503.2   06.78